# FASCICULE DE BREVET EUROPEEN

(11) **EP 3 624 908 B1**
(45) Date de publication et mention de la délivrance du brevet: **07.07.2021**
(21) Numéro de dépôt: 18725834.8
(22) Date de dépôt: 18.05.2018
(51) Int. Cl.: A63B 69/00

(54) **PRISE D'ESCALADE A DÉTECTION CAPACITIVE, PROCÉDÉ DE RÉALISATION ET MUR ASSOCIÉS**
KLETTERGRIFF MIT KAPAZITIVER DETEKTION, SOWIE HERSTELLUNGSVERFAHREN UND KLETTERWAND DAFÜR
CLIMBING HOLD WITH CAPACITIVE DETECTION, AND CORRESPONDING MANUFACTURING METHOD AND CLIMBING WALL

(30) Priorité: 18.05.2017 FR 1754398
(43) Date de publication de la demande: 25.03.2020
(73) Titulaire: X'Sin, 69400 Arnas (FR)
(72) Inventeur: GARNIER, Denis, 69460 Blace (FR); RUL, Valentin, 11100 Narbonne (FR)
(74) Mandataire: Cabinet Laurent & Charras
(86) Numéro de dépôt international: PCT/EP2018/063063
(87) Numéro de publication internationale: WO 2018/211062

(56) Documents cités:
- DE-B3-102013 002 287
- JP-A- 2001 303 595
- US-B1- 8 808 145
- US-B1- 9 539 483

## Description

### DOMAINE TECHNIQUE

La présente invention concerne le domaine des prises d'escalade ainsi que les procédés de réalisation des prises d'escalade et les murs associés.

L'invention concerne plus particulièrement les prises d'escalade adaptées pour réaliser une détection capacitive des grimpeurs.

### ART ANTERIEUR

Les prises d'escalade sont classiquement fabriquées par coulée d'une résine polyester ou polyuréthane dans des moules en silicone. Le polyuréthane s'obtient par association d'un isocyanate et d'un alcool. Le polyester peut être mélangé avec de la silice pour obtenir une prise plus résistante aux efforts de serrage. Lorsque la préparation liquide est obtenue, un catalyseur est ajouté dans la préparation pour obtenir un durcissement de la préparation liquide. Avant que la préparation liquide ne durcisse complètement, la préparation liquide est coulée dans un moule en silicone.

Un mur d'escalade classique est composé de planches de bois résinées et sablées sur lesquelles des prises sont fixées par l'intermédiaire d'un point d'ancrage. Ce point d'ancrage peut être simplement une vis à bois, traversant la prise, et vissée dans le mur. De préférence, le point d'ancrage correspond à un système vis/insert fileté avec une vis à tête creuse. La tête de la vis est insérée dans une cavité de la prise alors que le corps de la vis s'étend à travers un évidement de la prise et du mur de sorte à déboucher de l'autre côté du mur et être serrée par un écrou de type insert encastré à l'arrière du mur.

Avec ce système vis/écrou, un courant électrique appliqué sur l'écrou peut traverser la prise et le mur pour être capté au niveau de la tête de la vis. Il est donc possible de réaliser une détection capacitive d'un grimpeur.

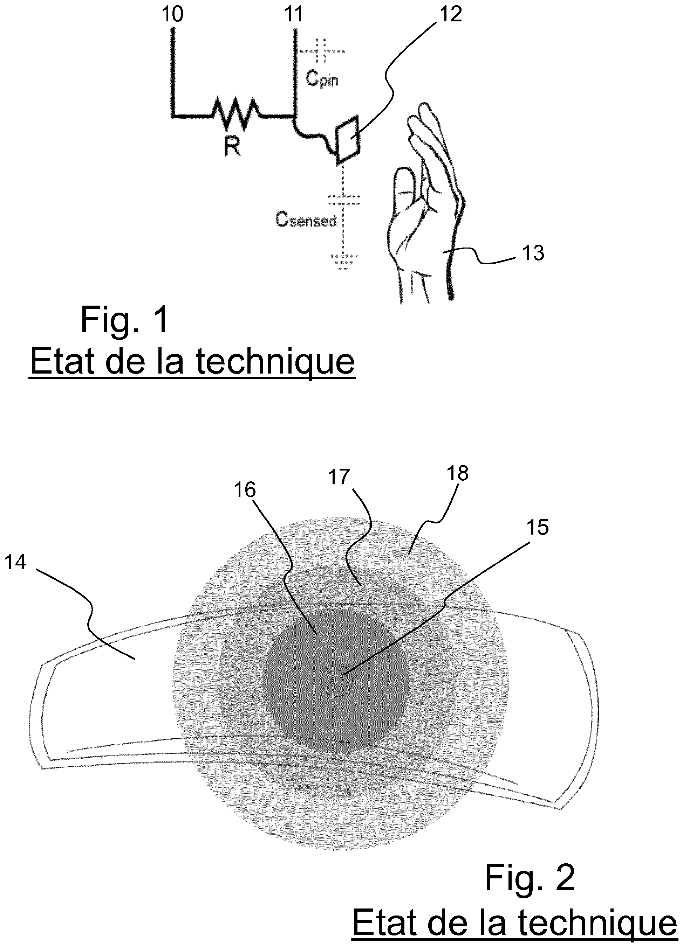

La détection capacitive s'appuie sur le fait que le corps humain est conducteur. Tel qu'illustré sur la figure 1, le corps du grimpeur (13) agit comme une électrode qui vient en regard d'une autre électrode (12) rattachée à un circuit d'acquisition par l'écrou. Le circuit d'acquisition comporte simplement une borne d'entrée (10) et une borne de sortie (11) reliées par une résistance (R). L'écrou est connecté entre la résistance (R) et la borne de sortie (11). La connexion de l'écrou avec le circuit d'acquisition forme une première capacité résiduelle (Cpin).

Pour détecter le contact du grimpeur (13), un faible courant est émis par la borne d'entrée (10) et ce faible courant est transmis jusqu'à l'écrou puis jusqu'à la prise d'escalade par l'intermédiaire de la vis. Si le grimpeur touche la prise, une seconde capacité résiduelle (Csensed) est créée par le corps du grimpeur formant ainsi un circuit RC induisant une décharge du corps du grimpeur dans le circuit d'acquisition. Cette décharge peut être détectée sur la borne de sortie (11).

Dans un mur d'escalade à détection capacitive, chaque prise est connectée à un circuit d'acquisition spécifique et il est possible d'identifier la ou les prises touchées par le grimpeur au cours du temps. Cette technologie améliore l'analyse des performances des grimpeurs, notamment pour les compétitions de vitesse.

Cette technologie est connue de la demande de brevet français N° FR 3006797 de la demanderesse et du brevet américain N° US 8,808,145.

Le problème de cette technologie réside dans la détection du grimpeur. En effet, tel qu'illustré sur la figure 2, la détection du grimpeur est homogène sur une demi-sphère globalement circulaire autour de la tête de la vis (15) dans l'air. Un premier cercle (16) illustre la zone de la prise (14) dans laquelle la détection est optimale. Dans le second cercle (17) le courant induit par la détection est plus faible quand dans le premier cercle (16). Dans le troisième cercle (18) le courant induit par la détection est encore plus faible et, au-delà de ce troisième cercle (18) le grimpeur (13) n'est plus détectable.

De plus, DE 10 2013 002287 B3 dévoile les caractéristiques du préambule de la revendication 1.

Ainsi, le problème technique de l'invention est d'améliorer la détection capacitive des prises d'escalade. Cependant, cette amélioration ne doit pas se faire au détriment du toucher des prises d'escalade qui vise à reproduire le contact d'une roche naturelle.

### EXPOSE DE L'INVENTION

La présente invention propose de répondre à ce problème technique en intégrant des particules conductrices dans la matrice polymérique de la prise d'escalade.

Selon un premier aspect, l'invention concerne une prise d'escalade à détection capacitive comportant :
- au moins une matrice polymérique; et
- un point d'ancrage ménagé dans ladite matrice polymérique, ledit point d'ancrage étant destiné à fixer ladite prise d'escalade sur un mur d'escalade et à transmettre un contact capacitif à un ensemble de détection capacitif.

L'invention se caractérise en ce que ladite matrice polymérique intègre une poudre de carbone de sorte que ladite poudre de carbone représente entre 5% et 35% du poids de ladite matrice polymérique et préférentiellement entre 10% et 35% du poids de ladite matrice polymérique, ladite poudre de carbone étant répartie sensiblement équitablement dans ladite matrice polymérique.

L'invention permet d'obtenir une prise d'escalade dont la détection capacitive est réalisée sur une plus grande surface que les prises existantes car les charges électriques peuvent être transmises dans la prise d'escalade en utilisant un réseau antistatique formé par la poudre de carbone.

L'intégration de particules conductrices dans une prise d'escalade est particulièrement contre intuitive car les particules conductrices sont classiquement réalisées par des éléments métalliques sous forme de poudre ou de fibres. Or, les fibres métalliques intégrées dans une prise d'escalade augmentent le risque de coupure car elles apparaissent en surface et dégradent ainsi l'expérience utilisateur.

En outre, l'homme du métier des prises d'escalade sait que la grande majorité des poudres métalliques présentent des densités importantes difficiles à intégrer dans une matrice polymérique d'une prise d'escalade.

Par exemple, avec des poudres métalliques très denses, c'est-à-dire supérieurs à 3.5 g/cm³, l'incorporation de la poudre métallique dans la matrice polymérique forme un mélange inhomogène car la charge sédimente.

Ces préjugés techniques ont été surmontés par la présente invention en utilisant une poudre de carbone comme élément conducteur. Bien qu'ayant une conductivité plus faible que les matériaux conducteurs métalliques (argent, cuivre, or, aluminium, zinc, nickel, fer, étain, platine, palladium, plomb), la faible masse volumique du carbone, généralement inférieure à 2.3 g/cm³, a permis la formation d'un mélange homogène avec la matrice polymérique.

Les tests de l'invention ont montrés que, pour une masse de carbone trop faible par rapport à la masse total du corps de la prise d'escalade, c'est-à-dire inférieure à 5%, la détection capacitive n'est que peu impactée car les particules de carbones ne sont pas suffisantes pour créer un réseau antistatique dans la prise d'escalade. En outre, pour une masse trop importante, c'est-à-dire supérieure à 35%, la viscosité du mélange devient trop importante pour qu'il soit compatible avec le procédé de coulée libre.

L'invention a donc mis au jour un ratio, entre 5% et 35% et préférentiellement entre 10% et 35%, dans lequel la poudre de carbone améliore les propriétés de transmissions capacitives sans dégrader fortement la tenue mécanique de la prise d'escalade.

Selon l'invention, la caractéristique selon laquelle la poudre de carbone est répartie sensiblement équitablement dans ladite matrice polymérique indique que, pour une prise constituée par une seule matrice polymérique, chaque volume élémentaire de la prise, avec un volume de 1 cm³, comporte au moins la moitié de la proportion de poudre de carbone prévues dans la prise : entre 5% et 35% en poids et préférentiellement entre 10% et 35% en poids. Ainsi, chaque volume élémentaire de la prise contient au moins 2.5% de poudre de carbone et préférentiellement au moins 5% de poudre de carbone. Cette caractéristique assure la continuité du réseau antistatique dans la prise.

En outre, les prises d'escalade peuvent être vendues avec ou sans les moyens de fixation. Généralement, les moyens de fixation se présentent sous la forme d'une vis traversant un alésage de la prise d'escalade. Dans ce cas, la prise d'escalade comporte une cavité destinée à contenir la tête de la vis dans la prise d'escalade.

En variante, la prise d'escalade peut être surmoulée sur la vis. Dans ce cas, les ratios de poids de la matrice polymérique de l'invention sont à considérer en retirant le poids de la vis par rapport au poids de la prise d'escalade.

En variante, ladite prise d'escalade comporte deux matrices polymériques, au moins une matrice polymérique intégrant une poudre de carbone de sorte que ladite poudre de carbone représente entre 5% et 35% du poids de ladite matrice polymérique, et préférentiellement entre 10% et 35% du poids de ladite matrice polymérique. Ce mode de réalisation vise les prises bi-matières. Dans ce cas, il faut isoler des deux matières pour mesurer les ratios de poids de la poudre de carbone par rapport à la matrice polymérique intégrant la poudre de carbone.

Selon un mode de réalisation, ladite poudre de carbone correspond à du noir de carbone à haute structure. Les essais ont montrés que le noir de carbone à haute structure est particulièrement efficace pour assurer l'homogénéité du mélange entre la poudre de carbone et la matrice polymérique.

Selon un mode de réalisation, ladite poudre de carbone correspond à de la poudre de graphite. Les essais ont également montrés que la poudre de graphite est particulièrement efficace pour assurer l'homogénéité du mélange entre la poudre de carbone et la matrice polymérique.

Selon un mode de réalisation, ladite matrice polymérique intègre une poudre de silice. L'utilisation de silice dans une prise d'escalade permet d'augmenter la résistance mécanique aux chocs de la prise d'escalade lors du serrage de la prise d'escalade sur un mur d'escalade. Les tests ont montrés que la poudre de silice a une influence négligeable sur le signal de détection car la silice n'entraine pas de discontinuité du réseau antistatique formé par les éléments de carbone.

Selon un mode de réalisation, ladite matrice polymérique intègre entre 5% et 35% en poids de poudre de carbone, préférentiellement entre 20% et 30% en poids de poudre de carbone, et entre 20% et 60% en poids de silice, préférentiellement entre 40% et 60% en poids de silice. Les tests ont montrés que ce ratio entre la poudre de carbone, la silice et le poids de la prise d'escalade était particulièrement efficace pour garantir l'homogénéité du mélange pour la réalisation de la prise d'escalade.

Selon un second aspect, l'invention concerne un procédé de fabrication d'une prise d'escalade à détection capacitive comportant les étapes successives suivantes :
- préparation d'une résine polymérique ;
- incorporation d'une poudre de carbone représentant entre 5% et 35% du poids de ladite résine polymérique, et préférentiellement entre 10% et 35% du poids de ladite résine polymérique;
- agitation du mélange intégrant ladite résine polymérique et la poudre de carbone ;
- placement du mélange sous une cloche à vide de sorte à dégazer le mélange ;
- ajout d'un catalyseur au mélange avant ou après l'étape d'agitation du mélange; et
- moulage du mélange de sorte à former ladite prise d'escalade.

Contrairement à la fabrication d'une prise d'escalade classique, l'ajout de poudre de carbone nécessite une agitation de la résine polymérique et de la poudre de carbone de sorte à garantir l'homogénéité du mélange. Cette étape d'agitation induit la formation de bulles d'air dans le mélange et, contrairement à l'état de la technique, une étape supplémentaire de dégazage est nécessaire pour extraire ces bulles d'air et obtenir une prise d'escalade avec une bonne tenue mécanique.

Pour réaliser une prise bi-matière en incorporant une résine polymérique avec de la poudre de carbone, l'invention propose trois variantes distinctes.

Dans une première variante, le procédé comporte les étapes supplémentaires suivantes :
- préparation d'une seconde résine polymérique sans propriétés antistatique ;
- ajout d'un catalyseur dans la seconde résine polymérique ; et
- moulage de ladite seconde résine polymérique lors de l'étape de moulage du mélange de sorte à former une prise d'escalade marbrée.

Cette première variante permet d'obtenir une prise bi-matière marbrée, c'est-à-dire avec deux matières mélangées ensemble lors du moulage. La résine polymérique chargée assure la détection capacitive lors du contact avec la main ou le pied du grimpeur alors que la résine polymérique non chargée est de couleur différente pour donner un rendu esthétique spécifique.

Dans une seconde variante, le procédé comporte les étapes supplémentaires suivantes :
- préparation d'une seconde résine polymérique sans propriétés antistatique;
- ajout d'un catalyseur dans la seconde résine polymérique ; et
- moulage de ladite seconde résine polymérique avant ou après l'étape de moulage du mélange.

Cette seconde variante permet d'obtenir une prise bi-matière avec deux épaisseurs de matières différentes. L'épaisseur de résine polymérique chargée assure la détection capacitive lors du contact avec la main ou le pied du grimpeur alors que la résine polymérique non chargée est de couleur différente pour donner un rendu esthétique spécifique.

Dans une troisième variante, le procédé comporte les étapes supplémentaires suivantes :
- application d'un contre-moule avant l'étape de moulage du mélange de sorte à former une cavité dans ladite prise d'escalade ;
- préparation d'une seconde résine polymérique sans propriétés antistatique;
- ajout d'un catalyseur dans la seconde résine polymérique ; et
- moulage de ladite seconde résine polymérique dans ladite cavité ménagée par l'application du contre-moule.

Cette troisième variante permet d'obtenir une prise bi-matière avec une croute formée par le mélange entre la première résine et la poudre de carbone destinée à entrer au contact avec la main ou le pied du grimpeur alors que le centre de la prise intègre une seconde résine sans propriétés antistatiques.

Selon un mode de réalisation, l'étape d'incorporation de ladite poudre de carbone comporte l'ajout d'un agent dispersant. Ce mode de réalisation vise à améliorer la répartition de la poudre de carbone dans le mélange.

Selon un mode de réalisation, l'étape de préparation d'une résine polymérique comporte l'ajout de silice.

Ce mode de réalisation permet d'augmenter la résistance mécanique aux chocs de la prise d'escalade lors du serrage de la prise d'escalade sur un mur d'escalade.

Selon un mode de réalisation, l'étape d'agitation du mélange est réalisée avec une vitesse comprise entre 10m/s et 20m/s. Cette vitesse correspond à la vitesse de déplacement du mélange. L'agitation peut être effectuée par un mouvement de va-et-vient avec une vitesse de déplacement de l'outil comprise entre 10m/s et 20m/s. En variante, l'agitation peut être réalisée par un mouvement circulaire au moyen d'un outil immergé dans le mélange, cette vitesse linéaire correspond alors à la vitesse de l'extrémité des pales de l'outil. Ce mode de réalisation permet de garantir une dispersion efficace de la poudre de carbone dans le mortier.

Selon un mode de réalisation, ladite résine polymérique correspond à une matrice polyester.

Selon un mode de réalisation, ladite résine polymérique correspond à une matrice polyuréthane.

Selon un troisième aspect, l'invention concerne un mur d'escalade connecté comportant :
- des prises d'escalade selon le premier aspect de l'invention, et
- un ensemble de détection capacitif relié à chaque prise et configuré pour détecter le contact d'un grimpeur sur chaque prise.

### DESCRIPTION SOMMAIRE DES FIGURES

La manière de réaliser l'invention ainsi que les avantages qui en découlent, ressortiront bien du mode de réalisation qui suit, donné à titre indicatif mais non limitatif, à l'appui des figures annexées dans lesquelles les figures 1 à 5 représentent :
- figure 1 : une représentation schématique du schéma électrique de principe de la détection capacitive d'une prise d'escalade de l'état de la technique ;
- figure 2 : une vue de face d'une prise d'escalade à détection capacitive de l'état de la technique ;
- figure 3 : une vue de face d'une prise d'escalade à détection capacitive de l'invention ;
- figure 4 : une représentation schématique de l'évolution du taux de détection de la prise de la figure 3 en fonction du pourcentage de particules conductrices ; et
- figure 5 : un organigramme des étapes de réalisation de la prise de la figure 3.

### DESCRIPTION DETAILLEE DE L'INVENTION

Dans cette partie, il est décrit une prise d'escalade dont le corps comporte une seule matrice polymérique mais plusieurs matrices polymériques peuvent être utilisées sans changer l'invention.

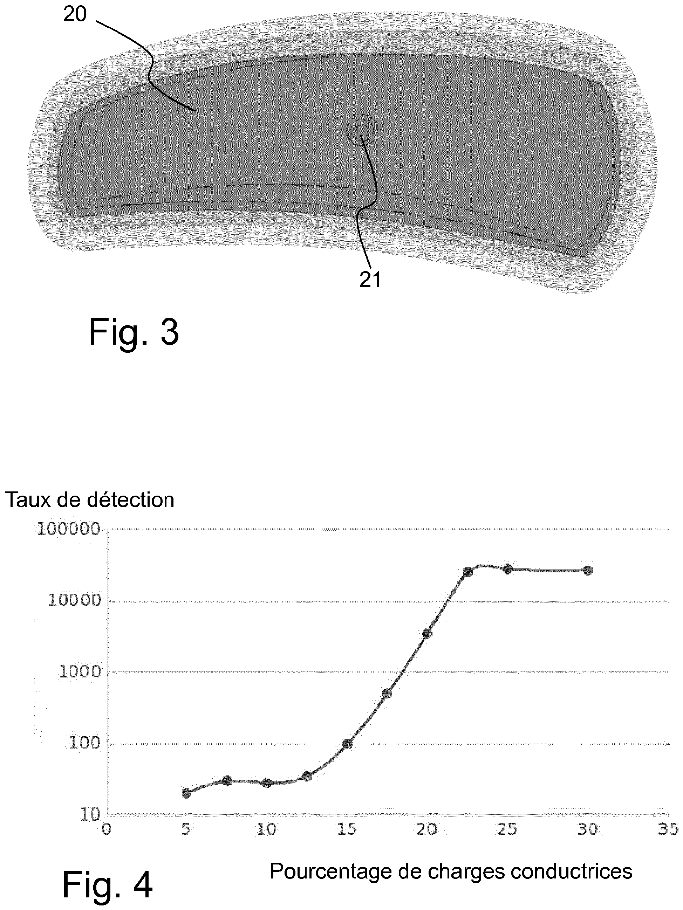

La figure 3 illustre une prise d'escalade à détection capacitive **20** selon un mode de réalisation de l'invention. La prise d'escalade **20** est fixée sur un mur par une vis à tête creuse **21.** Pour ce faire, la tête de la vis **21** est intégrée dans une cavité de la prise **20** et le corps de la vis **21** traverse un évidement du corps de la prise d'escalade **20.**

La vis **21** est fixée sur un mur d'escalade par un écrou connecté à un circuit d'acquisition analogue à ceux de l'état de la technique. Le corps de la prise d'escalade **20** comporte une matrice polymérique **22** et une poudre conductrice **23.** La poudre conductrice **23** correspond à une poudre de carbone, telle que le noir de carbone à haute structure ou la poudre de graphite. Par exemple, la poudre de graphite de la société Inoxia Ltd ® peut être utilisée.

La matrice polymérique **22** peut être une matrice en polyester, en polyuréthane ou toute autre résine compatible. Par exemple, une matrice en polyester PO 820 de la marque Polyprocess peut être utilisée.

La proportion de particules conductrices **23** est particulièrement sensible pour transmettre les charges électrostatiques du grimpeur au circuit d'acquisition. La figure 4 illustre le taux de détection en fonction du pourcentage, en poids, des particules conductrices **23** pour une prise d'escalade **20** comportant une matrice en polyester associée à une poudre de graphite. L'amélioration de la détection du grimpeur intervient à partir du ratio de 5% du poids de la prise d'escalade **20** et se stabilise après un ratio de 25%.

Tel qu'illustré sur la figure 3, pour une prise d'escalade intégrant 25% de poudre de graphite, 50% de silice et une matrice en polyester et préférentiellement 30% de silice, la détection du grimpeur est homogène sur l'ensemble de la prise **20** révélant que la poudre de carbone **23** est particulièrement efficace pour transmettre les charges électrostatiques du grimpeur au circuit d'acquisition.

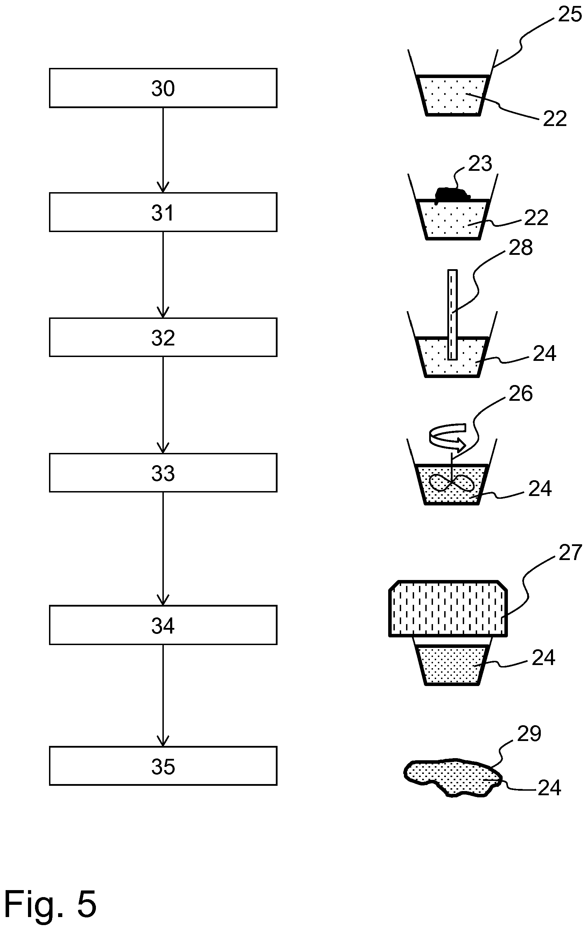

La réalisation d'une telle prise d'escalade 20 est obtenue par le processus décrit sur la figure 5. La première étape **30** consiste à formuler la matrice polymérique **22.** De préférence, la matrice polymérique **22** est formulée dans un bac **25** à partir d'une résine polyester ou polyuréthane. Le polyuréthane s'obtient par association d'un isocyanate et d'un alcool. Le polyester peut être mélangé avec de la silice pour obtenir une prise **20** plus résistante aux efforts de serrage.

Lorsque la matrice polymérique **22** est obtenue, dans une seconde étape **31,** une poudre de carbone **23** est incorporée à la matrice polymérique **22.** Le poids de la poudre de carbone **23** est déterminé en fonction des propriétés recherchées mais le poids de la poudre de carbone **23** doit être compris entre 5% et 35% du poids de l'ensemble formé par la matrice polymérique **22** et la poudre de carbone **23,** et préférentiellement entre 10% et 35% du poids de l'ensemble. En plus de la poudre de carbone **23,** un agent dispersant peut être incorporé à la matrice polymérique **22** pour améliorer la répartition de la poudre de carbone. L'agent dispersant peut correspondre à la référence BYK-W 969 de la marque BYK et la proportion de l'agent dispersant peut être choisie entre 0 et 20% du poids de la matrice polymérique **22.**

La poudre de carbone **23** est ensuite mélangée avec la matrice polymérique **22,** dans une troisième étape **32.** L'agitation peut être réalisée par un mélangeur **26** animé par un mouvement de rotation induisant un déplacement linéaire compris entre 10m/s et 20m/s à l'extrémité des pales du mélangeur **26.** Par exemple, une agitation de 5 minute peut permettre une bonne répartition de la poudre de carbone **23** dans la matrice polymérique **22.**

A cette étape, le mélange représente sensiblement le poids de la prise d'escalade **20.** Dans le cas d'une matrice en polyester, le mélange **24** peut intégrer entre 5% et 35% en poids de poudre de carbone **23,** préférentiellement entre 20% et 30en poids de poudre de carbone **23,** et entre 20% et 60% en poids de silice, préférentiellement entre 40% et 60% en poids de silice.

Dans une quatrième étape 33, pour extraire les bulles d'air, le mélange 24 ainsi obtenu est placé sous une cloche à vide **27.** Un catalyseur **28** est ensuite ajouté, dans une cinquième étape **34,** au mélange **24** pour obtenir un durcissement du mélange **24.** Avant que le mélange **24** ne durcisse complètement, le mélange **24** est coulé dans un moule en silicone **29** dans une sixième étape **35.** En variante, le catalyseur **28** peut être intégré au mélange **24** avant les étapes d'agitation **33** et de dégazage **34.**

Le mélange **24** durcit dans le moule pour former une prise d'escalade **20** telle qu'illustrée sur la figure 3. Dans cette étape de solidification, une vis métallique **21** peut être insérée dans le mélange ou la forme du moule peut être adaptée pour former une cavité et un évidement destinés au positionnement de la vis **21.**

Ensuite, un ensemble de prises **20** peut être utilisé pour former un mur d'escalade à détection capacitive en reliant chaque vis **21** de chaque prise **20** avec un ensemble de détection capacitif apte à détecter le contact d'un grimpeur sur chaque prise **20.**

L'invention permet d'améliorer la détection du contact d'un grimpeur en tout point de la surface d'une prise **20** car les particules de carbone dans la prise **20** forment un réseau antistatique permettant de transmettre un faible courant. En effet, lorsque deux particules de carbone sont proches, un courant électrostatique peut être transmis entre les deux particules par l'intermédiaire d'un effet tunnel. Il s'ensuit que l'invention permet d'améliorer la détection d'un grimpeur sur une prise à détection capacitive.

## Revendications

1. Prise d'escalade à détection capacitive (20) comportant :
- au moins une matrice polymérique (22); et
- un point d'ancrage (21) ménagé dans ladite matrice polymérique (22), ledit point d'ancrage (21) étant destiné à fixer ladite prise d'escalade (20) sur un mur d'escalade et à transmettre un contact capacitif à un ensemble de détection capacitif ;
***caractérisée en ce que*** ladite matrice polymérique (22) intègre une poudre de carbone (23) de sorte que ladite poudre de carbone (23) représente entre 5% et 35% du poids de ladite matrice polymérique (22), et préférentiellement entre 10% et 35% du poids de ladite matrice polymérique (22), ladite poudre de carbone (23) étant répartie sensiblement équitablement dans ladite matrice polymérique (22).

2. Prise d'escalade à détection capacitive selon la revendication 1, dans laquelle ladite prise d'escalade comporte deux matrices polymériques, au moins une matrice polymérique (22) intégrant une poudre de carbone (23) de sorte que ladite poudre de carbone (23) représente entre 5% et 35% du poids de ladite matrice polymérique (22) et préférentiellement entre 10% et 35% du poids de ladite matrice polymérique (22).

3. Prise d'escalade à détection capacitive selon la revendication 1 ou 2, dans laquelle ladite poudre de carbone (23) correspond à du noir de carbone à haute structure.

4. Prise d'escalade à détection capacitive selon la revendication 1 ou 2, dans laquelle ladite poudre de carbone (23) correspond à de la poudre de graphite.

5. Prise d'escalade à détection capacitive selon l'une des revendications 1 à 4, dans laquelle ladite matrice polymérique (22) intègre une poudre de silice.

6. Prise d'escalade à détection capacitive selon la revendication 5, dans laquelle ladite matrice polymérique (22) intègre entre 5% et 35% en poids de poudre de carbone (23), préférentiellement entre 20% et 30% en poids de poudre de carbone (23), et entre 20% et 60% en poids de silice, préférentiellement entre 40% et 60% en poids de silice.

7. Procédé de fabrication d'une prise d'escalade à détection capacitive comportant les étapes successives suivantes :
- préparation (30) d'une résine polymérique (22) ;
- incorporation (31) d'une poudre de carbone (23) représentant entre 5% et 35% du poids de ladite résine polymérique (22), et préférentiellement entre 10% et 35% du poids de ladite résine polymérique (22) ;
- agitation (32) du mélange (24) intégrant ladite résine polymérique (22) et la poudre de carbone (23) ;
- placement (33) du mélange (34) sous une cloche à vide (27) de sorte à dégazer le mélange (24) ;
- ajout (34) d'un catalyseur (28) au mélange (24) avant ou après l'étape d'agitation (32) du mélange (24) ; et
- moulage (35) du mélange (34) de sorte à former ladite prise d'escalade (20).

8. Procédé de fabrication d'une prise d'escalade à détection capacitive selon la revendication 7 comportant les étapes supplémentaires suivantes :
- préparation d'une seconde résine polymérique sans propriétés antistatique ;
- ajout d'un catalyseur dans la seconde résine polymérique ; et
- moulage de ladite seconde résine polymérique lors de l'étape de moulage (35) du mélange (34) de sorte à former une prise d'escalade (20) marbrée.

9. Procédé de fabrication d'une prise d'escalade à détection capacitive selon la revendication 7 comportant les étapes supplémentaires suivantes :
- préparation d'une seconde résine polymérique sans propriétés antistatique ;
- ajout d'un catalyseur dans la seconde résine polymérique ; et
- moulage de ladite seconde résine polymérique avant ou après l'étape de moulage (35) du mélange (34).

10. Procédé de fabrication d'une prise d'escalade à détection capacitive selon la revendication 7 comportant les étapes supplémentaires suivantes :
- application d'un contre-moule avant l'étape de moulage (35) du mélange (34) de sorte à former une cavité dans ladite prise d'escalade (20) ;
- préparation d'une seconde résine polymérique sans propriétés antistatique ;
- ajout d'un catalyseur dans la seconde résine polymérique ; et
- moulage de ladite seconde résine polymérique dans ladite cavité ménagée par l'application du contre-moule.

11. Procédé de fabrication d'une prise d'escalade à détection capacitive selon l'une des revendications 7 à 10, dans lequel l'étape d'incorporation (31) de ladite poudre de carbone (23) comporte l'ajout d'un agent dispersant dans ladite résine polymérique (22).

12. Procédé de fabrication d'une prise d'escalade à détection capacitive selon l'une des revendications 7 à 11, dans lequel l'étape de préparation (30) d'une résine polymérique (22) comporte l'ajout de silice.

13. Procédé de fabrication d'une prise d'escalade à détection capacitive selon l'une des revendications 7 à 12, dans lequel l'étape d'agitation (32) du mélange (24) est réalisée avec une vitesse comprise entre 10m/s et 20m/s.

14. Procédé de fabrication d'une prise d'escalade à détection capacitive selon l'une des revendications 7 à 13, dans lequel ladite résine polymérique (22) correspond à une matrice polyester.

15. Procédé de fabrication d'une prise d'escalade à détection capacitive selon l'une des revendications 7 à 14, dans lequel ladite résine polymérique (22) correspond à une matrice polyuréthane.

16. Mur d'escalade connecté comportant :
- des prises d'escalade (20) selon l'une des revendications 1 à 6, et
- un ensemble de détection capacitif relié à chaque prise (20) et configuré pour détecter le contact d'un grimpeur sur chaque prise (20).

## Patentansprüche

1. Klettergriff mit kapazitiver Detektion (20), der enthält:
- mindestens eine Polymermatrix (22); und
- einen Verankerungspunkt (21), ausgespart in dieser Polymermatrix (22), wobei dieser Verankerungspunkt (21) dazu bestimmt ist, diesen Klettergriff (20) an einer Kletterwand zu befestigen und einen kapazitiven Kontakt an eine kapazitive Detektionseinheit zu übertragen;
***dadurch gekennzeichnet, dass*** die erwähnte Polymermatrix (22) ein Kohlenstoffpulver (23) enthält, so dass dieses Kohlenstoffpulver (23) zwischen 5 % und 35 % des Gewichtes dieser Polymermatrix (22) enthält, und vorzugsweise zwischen 10 % und 35 % des Gewichtes dieser Polymermatrix (22), wobei das erwähnte Kohlenstoffpulver (23) dabei im Wesentlichen gleichmäßig in dieser Polymermatrix (22) verteilt ist.

2. Klettergriff mit kapazitiver Detektion nach Anspruch 1, bei der dieser Klettergriff zwei Polymermatrizes enthält, wobei mindestens eine Polymermatrix (22) dabei ein Kohlenstoffpulver (23) beinhaltet, so dass dieses Kohlenstoffpulver (23) zwischen 5 % und 35 % des Gewichtes dieser Polymermatrix (22) darstellt, und vorzugsweise zwischen 10 % und 35 % des Gewichtes dieser Polymermatrix (22).

3. Klettergriff mit kapazitiver Detektion nach Anspruch 1 oder 2, bei dem dieses Kohlenstoffpulver (23) hochstrukturiertem Kienruß entspricht.

4. Klettergriff mit kapazitiver Detektion nach Anspruch 1 oder 2, bei dem dieses Kohlenstoffpulver (23) Graphitpulver entspricht.

5. Klettergriff mit kapazitiver Detektion nach einem der Ansprüche 1 bis 4, bei dem diese Polymermatrix (22) Kieselerdepulver enthält.

6. Klettergriff mit kapazitiver Detektion nach Anspruch 5, bei dem diese Polymermatrix (22) zwischen 5 und 35 Gewichts-% Kohlenstoffpulver (23) enthält, vorzugsweise zwischen 20 und 30 Gewichts-% Kohlenstoffpulver (23), und zwischen 20 und 60 Gewichts-% Kieselerde, vorzugsweise zwischen 40 und 60 Gewichts-% Kieselerde.

7. Herstellungsverfahren für einen Klettergriff mit kapazitiver Erkennung, die die nachstehenden aufeinanderfolgenden Schritte enthält:
- Herstellung (30) eines Polymerharzes (22);
- Einbringen (31) eines Kohlenstoffpulvers (23), das zwischen 5 % und 35 % des Gewichtes dieser Polymerharzes (22) bildet, und vorzugsweise zwischen 10 % und 35 % des Gewichtes dieser Polymerharzes (22);
- Schütteln (32) der Mischung (24), die dieses Polymerharz (22) und das Kohlenstoffpulver (23) enthält;
- Mischung (34) in eine Vakuumglocke (27) stellen (33), so dass die Mischung (24) entgast wird;
- Zugabe (34) eines Katalysators (28) zu der Mischung (24) vor oder nach dem Schritt des Schüttelns (32) der Mischung (24); und
- Formen (35) der Mischung (34), um den erwähnten Klettergriff (20) zu formen.

8. Herstellungsverfahren für einen Klettergriff mit kapazitiver Erkennung, die die nachstehenden aufeinanderfolgenden Schritte enthält:
- Herstellung eines zweiten Polymerharzes ohne antistatische Eigenschaften;
- Zugabe eines Katalysators zum zweiten Polymerharz; und
- Formen dieses zweiten Polymerharzes beim Schritt der Formung (35) der Mischung (34), um so einen gemaserten Klettergriff (20) zu bilden.

9. Verfahren zur Herstellung eines Klettergriffs mit kapazitiver Detektion nach Anspruch 7, das aus den nachstehenden zusätzlichen Schritten besteht:
- Herstellung eines zweiten Polymerharzes ohne antistatische Eigenschaften;
- Zugabe eines Katalysators zum zweiten Polymerharz; und
- Gießen dieses zweiten Polymerharzes vor oder nach dem Schritt des Gießens (35) der Mischung (34).

10. Verfahren zur Herstellung eines Klettergriffs mit kapazitiver Detektion nach Anspruch 7, das aus den nachstehenden zusätzlichen Schritten besteht:
- Aufsetzen einer Gegenform vor dem Gießschritt (35) der Mischung (34), um so einen Hohlraum in diesem Klettergriff (20) zu formen;
- Herstellung eines zweiten Polymerharzes ohne antistatische Eigenschaften,
- Zugabe eines Katalysators zum zweiten Polymerharz; und
- Gießen dieses zweiten Polymerharzes in dieser durch das Aufsetzen der Gegenform ausgesparten Vertiefung.

11. Verfahren zur Herstellung eines Klettergriffs mit kapazitiver Detektion nach einem der Ansprüche 7 bis 10, bei dem der Schritt des Einbringens (31) des erwähnten Kohlenstoffpulvers (23) auch das Hinzufügen eines Dispergiermittels zu diesem Polymerharz (22) beinhaltet.

12. Verfahren zur Herstellung eines Klettergriffs mit kapazitiver Detektion nach einem der Ansprüche 7 bis 11, bei dem der Schritt der Herstellung (30) eines Polymerharzes (22) das Hinzufügen von Kieselerde beinhaltet.

13. Verfahren zur Herstellung eines Klettergriffs mit kapazitiver Detektion nach einem der Ansprüche 7 bis 12, bei dem der Schritt des Schüttelns (32) der Mischung (24) mit einer Geschwindigkeit zwischen 10m/s und 20m/s erfolgt.

14. Verfahren zur Herstellung eines Klettergriffs mit kapazitiver Detektion nach einem der Ansprüche 7 bis 13, bei dem dieses Polymerharz (22) einer Polyestermatrix entspricht.

15. Verfahren zur Herstellung eines Klettergriffs mit kapazitiver Detektion nach einem der Ansprüche 7 bis 14, bei dem dieses Polymerharz (22) einer Polyurethanmatrix entspricht.

16. Verbundene Kletterwand, die:
- Klettergriffe (20) nach einem der Ansprüche 1 bis 6, sowie
- eine kapazitive Detektionseinheit enthält, die mit jedem Griff (20) verbunden ist, um den Kontakt eines Kletterers mit dem jeweiligen Griff (20) zu erkennen.

## Claims

1. Capacitive sensing climbing hold (20) comprising:
- at least one polymeric matrix (22); and
- an anchor point (21) provided in said polymeric matrix (22), said anchor point (21) being configured to attach said climbing hold (20) on a climbing wall and to transmit a capacitive contact to a capacitive detection assembly; ***characterized in that*** said polymeric matrix (22) integrates a carbon powder (23) so that said carbon powder (23) represents between 5% and 35% of the weight of said polymeric matrix (22), and preferably between 10% and 35% of the weight of said polymeric matrix (22), said carbon powder (23) being distributed substantially evenly in said polymeric matrix (22).

2. A capacitive sensing climbing hold according to claim 1, wherein said climbing hold comprises two polymeric matrices, at least one polymeric matrix (22) incorporating a carbon powder (23) so that said carbon powder (23) represents between 5% and 35% of the weight of said polymeric matrix (22) and preferably between 10% and 35% of the weight of said polymeric matrix (22).

3. A capacitive sensing climbing hold according to claim 1 or 2, wherein said carbon powder (23) corresponds to high structure carbon black.

4. A capacitive sensing climbing hold according to claim 1 or 2, wherein said carbon powder (23) corresponds to graphite powder.

5. A capacitive sensing climbing hold according to one of claims 1 to 4, wherein said polymeric matrix (22) integrates a silica powder.

6. A capacitive sensing climbing hold according to claim 5, wherein said polymeric matrix (22) integrates between 5% and 35% by weight of carbon powder (23), preferably between 20% and 30% by weight of carbon powder (23), and between 20% and 60% by weight of silica, preferably between 40% and 60% by weight of silica.

7. A method of manufacturing a climbing hold with capacitive detection comprising the following successive steps:
- preparing (30) a polymeric resin (22);
- incorporating (31) a carbon powder (23) representing between 5% and 35% of the weight of said polymeric resin (22), and preferably between 10% and 35% of the weight of said polymeric resin (22);
- agitating (32) the mixture (24) integrating said polymeric resin (22) and carbon powder (23);
- placing (33) the mixture (34) under a vacuum bell (27) so as to degas the mixture (24);
- adding (34) a catalyst (28) to the mixture (24) before or after the agitating step (32) of the mixture (24); and
- molding (35) the mixture (34) so as to form said climbing hold (20).

8. A method of manufacturing a capacitive sensing climbing hold according to claim 7 comprising the following additional steps:
- preparation of a second polymeric resin without antistatic properties;
- adding a catalyst to the second polymeric resin; and
- molding said second polymeric resin during the molding step (35) of the mixture (34) to form a marbled climbing hold (20).

9. A method of manufacturing a capacitive sensing climbing hold according to claim 7 comprising the following additional steps:
- preparing a second polymeric resin without antistatic properties;
- adding a catalyst to the second polymeric resin; and
- molding said second polymeric resin before or after the molding step (35) of the mixture (34).

10. A method of manufacturing a capacitive sensing climbing hold according to claim 7 comprising the following additional steps:
- applying a back mold before the molding step (35) of the mixture (34) so as to form a cavity in said climbing hold (20);
- preparing a second polymeric resin without antistatic properties;
- adding a catalyst to the second polymeric resin; and
- molding said second polymeric resin in said cavity created by the application of the back mold.

11. A method of manufacturing a capacitive sensing climbing hold according to one of claims 7 to 10, wherein the step of incorporating (31) said carbon powder (23) comprises adding a dispersing agent into said polymer resin (22).

12. A method of manufacturing a capacitive sensing climbing hold according to one of claims 7 to 11, wherein the step of preparing (30) a polymeric resin (22) comprises adding silica.

13. A method of manufacturing a capacitive sensing climbing hold according to one of claims 7 to 12, wherein the agitating step (32) of the mixture (24) is carried out at a speed of between 10 m/s and 20 m/s.

14. A method of manufacturing a capacitive sensing climbing hold according to one of claims 7 to 13, wherein said polymeric resin (22) corresponds to a polyester matrix.

15. A method of manufacturing a capacitive sensing climbing hold according to one of claims 7 to 14, wherein said polymeric resin (22) corresponds to a polyurethane matrix.

16. Connected climbing wall comprising:
- climbing holds (20) according to one of claims 1 to 6, and
- a capacitive detection assembly connected to each hold (20) and configured to detect the contact of a climber on each hold (20).
